# EUROPÄISCHE PATENTANMELDUNG

(11) **EP 4 124 413 A1**
(43) Veröffentlichungstag der Anmeldung: **01.02.2023**
(21) Anmeldenummer: 21188656.9
(22) Anmeldetag: 30.07.2021
(51) Int. Cl.: B25D 17/04, B25F 5/02, H03K 17/97

(54) **VERFAHREN ZUM STEUERN UND REGELN EINER WERKZEUGMASCHINE**

(71) Anmelder: Hilti Aktiengesellschaft, 9494 Schaan (LI)
(72) Erfinder: Ringler, Stefan, 86853 Schwabmühlhausen (DE); Mahdizadeh, Ehsan, 86916 Kaufering (DE)
(74) Vertreter: Hilti Aktiengesellschaft Corporate Intellectual Property

(57) **Zusammenfassung**

Verfahren zum Steuern und Regeln einer Werkzeugmaschine (1), insbesondere eines Meißelhammers, enthaltend einen Antrieb (3), eine Steuerungseinrichtung (4), eine Sensoreinrichtung (13), einer Übertragungseinrichtung (6) und einer Handgriffvorrichtung (5), wobei die Handgriffvorrichtung (5) ein Hebelelement mit einem Signalgeber enthält, welches relativ zu der Sensoreinrichtung (13) schwenkbar ist. Eine erste und zweite Position des Signalgebers wird durch die Sensoreinrichtung (13) erfasst, wobei die Distanz zwischen der ersten und zweiten Position einer ersten Wegstrecke entspricht. Die Differenz zwischen einer maximalen Wegstrecke des Hebelelements und der ersten ermittelten Wegstrecke wird ermittelt. Eine erste Drehzahl wird für den Antrieb (3) eingestellt, wenn die ermittelte Differenz zwischen der maximalen Wegstrecke des Hebelelements und der ersten ermittelten Wegstrecke wenigstens einem ersten vorbestimmten Schwellwert entspricht. Eine zweiten Drehzahl wird für den Antrieb (3) eingestellt nach Erreichen der zweiten Position des Signalgebers und nach Ablauf einer vorbestimmten Zeitdauer.

## Beschreibung

Die vorliegende Erfindung betrifft ein Verfahren zum Steuern und Regeln einer Werkzeugmaschine, insbesondere eines Meißelhammers, enthaltend einen Antrieb, eine Steuerungseinrichtung, eine Sensoreinrichtung, einer Übertragungseinrichtung und einer Handgriffvorrichtung, wobei die Handgriffvorrichtung ein Hebelelement mit einem Signalgeber enthält, welches relativ zu der Sensoreinrichtung schwenkbar ist.

Ein Meißelhammer gemäß dem Stand der Technik wird zum Bearbeiten (d.h. Aufreißen, Abbrechen oder Meißeln) von mineralischen Werkstoffen, wie beispielsweise Beton, Ziegel oder dergleichen verwendet. Der Meißelhammer kann auch als Abbruch-, Abbau-, Aufbrechhammer, Breaker oder Floorbreaker bezeichnet werden. Der Meißelhammer verfügt über einen Antrieb, der mit Hilfe eines Übertragungsmechanismus Schläge auf ein Meißelwerkzeug (auch Meißel genannt) überträgt. Bei dem Antrieb kann es sich um einen Elektromotor, Hydraulikantrieb, Pneumatikantrieb oder Verbrennungsmotor handeln.

Für gewöhnlich weist der Meißelhammer zwei Handgriffe auf, welche an gegenüberliegenden Seiten des Gehäuses des Meißelhammers positioniert sind. Wenigstens einer der beiden Handgriffe umfasst einen Aktivierungsschalter, mit dem der Meißelhammer aktiviert bzw. eingeschaltet werden kann. Die Handgriffe erstrecken sich dabei meistens in einem stumpfen Winkel zu einer Längsachse des Gehäuses des Meißelhammers. Zur Verwendung des Meißelhammers wird der Aktivierungsschalter gedrückt und der Meißelhammer wird aktiviert, sodass Schläge von dem Antrieb auf den Meißel übertragen werden.

Ein Problem bei einem Meißelhammer gemäß dem Stand der Technik besteht darin, dass ein relativ unerfahrener Anwender oftmals Schwierigkeiten mit der Handhabung des Meißelhammers haben kann. Die Leistungsentfaltung und insbesondere die Schlagimpulse können ein sicheres und effizientes Arbeiten mit dem Meißelhammer erschweren.

Es ist somit Aufgabe der vorliegenden Erfindung das vorstehend erwähnte Problem zu lösen und Verfahren zum Steuern und Regeln einer Werkzeugmaschine, insbesondere eines Meißelhammers, bereitzustellen, welche ein sicheres und effizientes Arbeiten mit einer Werkzeugmaschine, insbesondere mit einem Meißelhammer, ermöglicht.

Die Aufgabe wird gelöst durch den Gegenstand in Anspruch 1. Vorteilhafte Ausführungsformen sind in den Unteransprüchen aufgeführt.

Die Aufgabe wird dabei gelöst durch ein Verfahren zum Steuern und Regeln einer Werkzeugmaschine, insbesondere eines Meißelhammers, enthaltend einen Antrieb, eine Steuerungseinrichtung, eine Sensoreinrichtung, einer Übertragungseinrichtung und einer Handgriffvorrichtung, wobei die Handgriffvorrichtung ein Hebelelement mit einem Signalgeber enthält, welches relativ zu der Sensoreinrichtung schwenkbar ist.

Erfindungsgemäß enthält das Verfahren die Verfahrensschritte:
- Erfassen einer ersten und zweiten Position des Signalgebers durch die Sensoreinrichtung, wobei die Distanz zwischen der ersten und zweiten Position einer ersten Wegstrecke entspricht;
- Ermitteln der Differenz zwischen einer maximalen Wegstrecke des Hebelelements und der ersten ermittelten Wegstrecke;
- Einstellen einer ersten Drehzahl für den Antrieb, wenn die ermittelte Differenz zwischen der maximalen Wegstrecke des Hebelelements und der ersten ermittelten Wegstrecke wenigstens einem ersten vorbestimmten Schwellwert entspricht; und
- Einstellen einer zweiten Drehzahl für den Antrieb, wenn ab dem Erreichen der zweiten Position des Signalgebers eine vorbestimmte Zeitdauer abgelaufen ist.

Die Übertragungseinrichtung erzeugt eine erste Schlagfrequenz und eine erste Leistungsentfaltung, wenn eine erste Drehzahl für den Antrieb eingestellt ist. Wenn eine zweite Drehzahl für den Antrieb eingestellt ist, erzeugt die Übertragungseinrichtung eine zweite Schlagfrequenz und eine zweite Leistungsentfaltung. Je höher die eingestellte Drehzahl für den Antrieb, desto höher die erzeugte Schlagfrequenz und die Leistungsentfaltung der Übertragungseinrichtung.

Gemäß einer vorteilhaften Ausgestaltung der vorliegenden Erfindung kann es möglich sein, dass die erste Drehzahl für den Antrieb einem vorbestimmten Anteil, insbesondere zwischen 60 und 80%, beispielsweise 75% der maximalen Drehzahl für den Antrieb entspricht.

Entsprechend einer weiteren vorteilhaften Ausgestaltung der vorliegenden Erfindung kann es möglich sein, dass der Schwellwert für die ermittelte Differenz zwischen der maximalen Wegstrecke und der ersten ermittelten Wegstrecke des Hebelelements einem vorbestimmten Anteil, insbesondere zwischen 25 und 75%, beispielsweise 50% der maximalen Wegstrecke entspricht.

Gemäß einer weiteren vorteilhaften Ausgestaltung der vorliegenden Erfindung kann es möglich sein, dass die vorbestimmte Zeitdauer einem Wert zwischen 0,75 und 2 Sekunden und insbesondere 1 Sekunde entspricht.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert. Es zeigen:
- Figur 1: eine schematische Vorderansicht auf eine Werkzeugmaschine in Form eines Meißelhammers;
- Figur 2a: eine Detailansicht auf eine Handgriffvorrichtung in einer ersten Position;
- Figur 2b: eine Detailansicht auf die Handgriffvorrichtung in einer zweiten Position; und
- Figur 2c: eine Detailansicht auf die Handgriffvorrichtung in einer dritten Position.

### Ausführungsbeispiele:

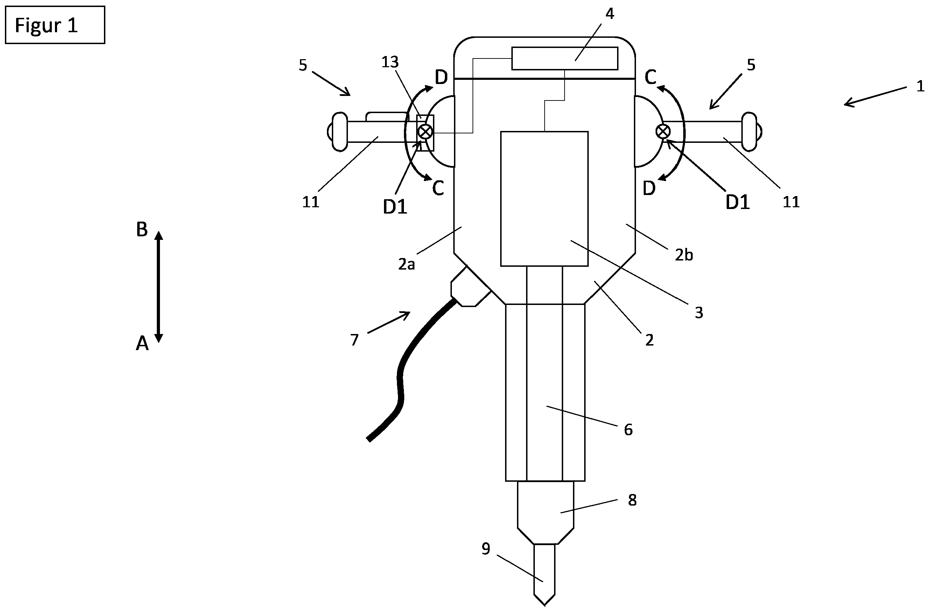

Figur 1 zeugt eine erfindungsgemäße Werkzeugmaschine 1 in Form eines Meißelhammers. Die Werkzeugmaschine 1 kann jedoch auch in Form eines Bohrhammers, einer Bohrmaschine, einer Säge, eines Schleifgeräts oder dergleichen ausgestaltet sein.

Wie in Figur 1 angedeutet, enthält die als Meißelhammer ausgestaltete Werkzeugmaschine 1 im Wesentlichen ein Gehäuse 2, einen Antrieb 3, eine Steuerungseinrichtung 4, eine erste und zweite Handgriffvorrichtung 5, eine Übertragungseinrichtung 6, eine Energieversorgungseinrichtung 7 sowie eine Werkzeugaufnahme 8.

Im Inneren des Gehäuses ist im Wesentlichen der Antrieb 3, die Steuerungseinrichtung 4 und die Übertragungseinrichtung 6 positioniert. Der Antrieb 3 ist dabei als Elektromotor ausgestaltet. Bei dem Elektromotor handelt es sich um einen bürstenlosen Elektromotor. Alternativ ist der Antrieb 3 als Elektromotor mit Kohlebürsten ausgestaltet. In allen Fällen enthält der als Elektromotor ausgestaltete Antrieb 3 einen Rotor und einen Stator. Der Rotor ist so im Inneren des Stators positioniert, dass sich der Rotor relativ zu dem Stator drehen kann. Der Rotor wird dabei von dem Stator angetrieben, sodass der Rotor ein Drehmoment erzeugen kann. Weder der Rotor noch der Stator sind in den Figuren gezeigt.

An einem unteren Ende des Gehäuses 2 der Werkzeugmaschine 1 ist die Werkzeugaufnahme 8 positioniert. Mit Hilfe der Werkzeugaufnahme 8 kann ein Werkzeug 9 aufgenommen und gehalten werden. In den Figuren ist das Werkzeug 9 als Meißel ausgestaltet.

Darüber hinaus ist an der ersten Seitenwand 2a des Gehäuses 2 der Werkzeugmaschine 1 die Energieversorgungseinrichtung 7 vorgesehen. In dem angeführten Beispiel der Werkzeugmaschine 1 handelt sich bei der Energieversorgungseinrichtung 7 um ein Stromnetzanschluss sowie um ein Stromnetzkabel. Ein freies Ende des Stromnetzkabels kann mit einem (nicht in den Figuren gezeigten) Stromnetzanschluss (auch Steckdose genannt) verbunden werden. Mit Hilfe der Energieversorgungseinrichtung 7 kann die Werkzeugmaschine 1 und insbesondere der als Elektromotor ausgestaltete Antrieb 3 mit Energie, beispielsweise mit elektrischer Energie, versorgt werden.

Entsprechend einer alternativen, in den Figuren nicht dargestellten Ausgestaltungsform der Werkzeugmaschine 1 kann die Energieversorgungseinrichtung 7 auch als ein einziger Akkumulator oder als mehrere Akkumulatoren ausgestaltet sein: Mit Hilfe einer oder mehreren Akku-Schnittstellen ist der einzelne oder mehrere Akkumulatoren an oder in dem Gehäuse 2 der Werkzeugmaschine 1 positioniert.

Wie bereits vorstehend erwähnt ist der Antrieb 3 in der vorliegenden Ausgestaltungsform der Werkzeugmaschine 1 als Elektromotor ausgestaltet. Alternativ kann es sich bei dem Antrieb 3 auch um einen Verbrennungsmotor handeln. In diesem Falle ist die Energieversorgungseinrichtung 7 als Treibstofftank ausgestaltet.

Gemäß einer weiteren alternativen Ausgestaltungsform der erfindungsgemäßen Werkzeugmaschine 1 kann der Antrieb 3 auch in Form eines pneumatischen Antriebs bzw. Kompressors ausgestaltet sein. Bei der Energieversorgungseinrichtung 7 kann es sich in diesem Fall um einen Druckluftanschluss oder Druckluftvorrat an oder in der Werkzeugmaschine 1 handeln.

Der als bürstenlose Elektromotor ausgestaltete Antrieb 3 dient zum Erzeugen eines Drehmoments. Mit Hilfe der Übertragungseinrichtung 6 kann das vom Antrieb 3 erzeugte Drehmoment in Form von Schlagimpulsen auf die Werkzeugaufnahme 8 und schließlich auf das als Meißel ausgestaltete Werkzeug 9 übertragen werden. Die Übertragungseinrichtung 6 kann auch als Schlagwerk bezeichnet werden und enthält im Wesentlichen eine Kolben-Zylinder-Vorrichtung. Die Kolben-Zylinder-Vorrichtung enthält dabei einen Kolben, der in dem Zylinder vor und zurück bewegt wird. Je höher die Frequenz des Kolbens in dem Zylinder desto höher die Schlagimpulsfrequenz und desto mehr Schlagenergie kann erzeugt sowie schließlich auf das Werkzeug übertragen werden.

Die Steuerungseinrichtung 4 ist mit der ersten und zweiten Handgriffvorrichtung 5 sowie mit dem Antrieb 3 verbunden. Signale und Kommunikationsdaten können somit zwischen den Handgriffvorrichtungen 5, dem Antrieb 3 und der Steuerungseinrichtung 4 gesendet und empfangen werden. Die Steuerungseinrichtung 4 dient zum Steuern und Regeln der unterschiedlichen Funktionen der Werkzeugmaschine 1 sowie insbesondere zum Einstellen der Parameter bzw. Betriebsparameter des Antriebs 3. Mit Hilfe der Steuerungseinrichtung 4 kann damit speziell die Drehzahl den Drehzahlwert des als Elektromotor ausgestalten Antriebs 3 als Parameter bzw. Betriebsparameter eingestellt werden.

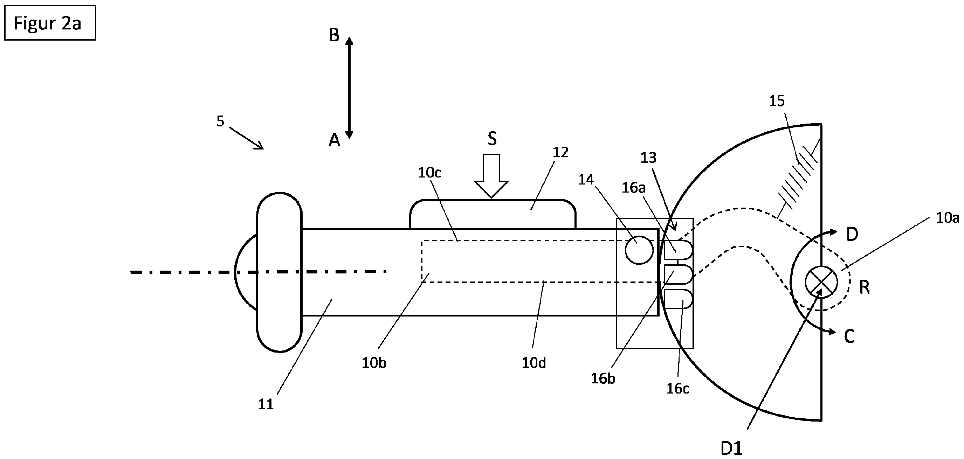

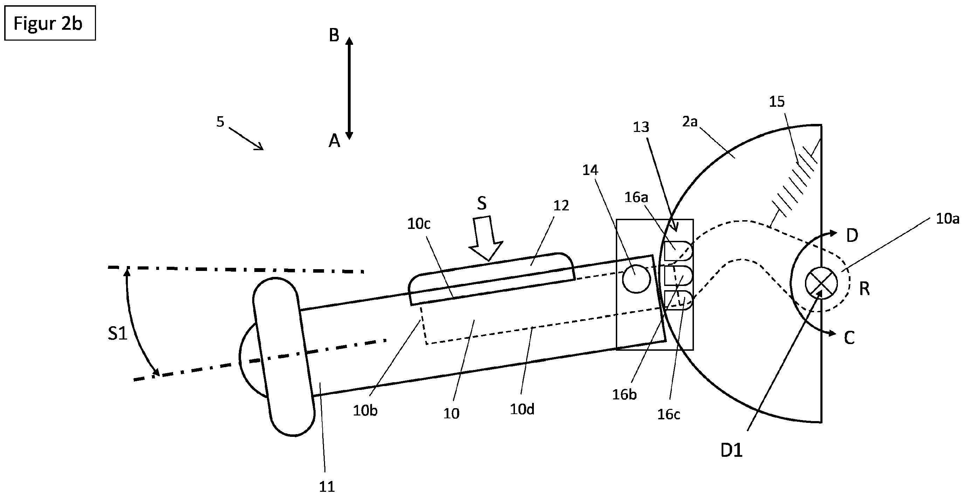

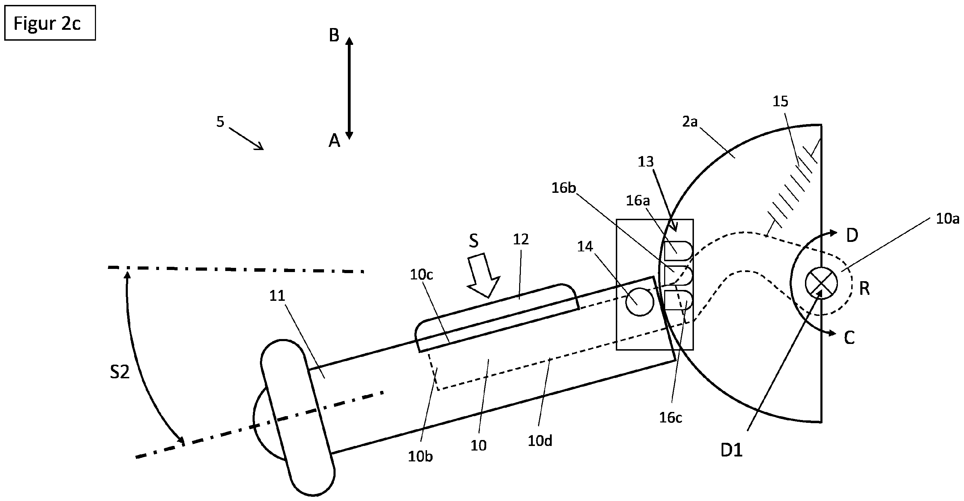

Die erste Handgriffvorrichtung 5 ist bewegbar an einer ersten Seitenwand 2a des Gehäuses 2 und die zweite Handgriffvorrichtung 5 ist bewegbar an einer zweiten Seitenwand 2b des Gehäuses 2 positioniert. Wie in Figur 1 und 2 gezeigt enthält sowohl die erste als auch die zweite Handgriffvorrichtung 5 jeweils ein Hebelelement 10 und ein Griffstück 11. Das jeweilige Hebelelement 10 der ersten und zweiten Handgriffvorrichtung 5 ist entsprechend über einen entsprechenden Drehpunkt D1 in Drehrichtung C oder D schwenkbar gelagert. Die erste und zweite Handgriffvorrichtung 5 dient zum Halten und Führen der Werkzeugmaschine 1 durch einen Anwender. Der Anwender ist in den Figuren nicht gezeigt.

In den Figuren 2a bis 2c ist die Handgriffvorrichtung 5 in Form eines beispielhaften Ausführungsbeispiels dargestellt. Die Handgriffvorrichtung 5 enthält dabei im Wesentlichen ein Hebelelement 10, ein Griffstück 11, ein Aktivierungselement 12, eine Sensoreinrichtung 13 sowie einen Signalgeber 14.

Das als Betätigungsschalter ausgestaltete Aktivierungselement 12 dient zum Aktivieren des Antriebs 3 der Werkzeugmaschine 1. Das Aktivierungselement 12 kann durch Ausüben einer Kraft in Richtung S reversibel von einer ersten Position in eine zweite Position gebracht wird. In Figur 2a ist das Aktivierungselement 12 in der ersten Position, d.h. in einem nicht gedrückten Zustand, gezeigt. Die erste Position entspricht dabei der obersten Position. Die Aktivierung des Antriebs 3 erfolgt sobald das Aktivierungselement 12 von der ersten Position in die zweite Position wegbewegt wird. In Figur 2b und 2c ist das Aktivierungselement 12 jeweils in der zweiten Position, d.h. in einem gedrückten Zustand, dargestellt. Das Aktivierungselement 12 ist so mit der Steuerungseinrichtung 4 verbunden, dass Signale zwischen dem Aktivierungselement 12 und der Steuerungseinrichtung 4 ausgetauscht werden können. Die Verbindung zwischen dem Aktivierungselement 12 und der Steuerungseinrichtung 4 ist in den Figuren nicht dargestellt. Die jeweilige Position, d.h. die erste oder zweite Position, des Aktivierungselements 12 wird an die Steuerungseinrichtung 4 mit Hilfe eines entsprechenden Signals übermittelt.

Alternativ kann in der Steuerungseinrichtung 4 aus den entsprechenden Signalen die erste und zweite Position ermittelt werden.

Wenn das Aktivierungselement 12 sich in der zweiten Position befindet, ist lediglich der Antrieb 3 der Werkzeugmaschine 1 aktiviert. Die als Schlagwerkeinrichtung ausgestaltete Übertragungseinrichtung 6 wird nicht nur durch das Drücken des Aktivierungselements 12 in Pfeilrichtung S aktiviert bzw. gestartet.

Die Sensoreinrichtung 13 ist so mit der Steuerungseinrichtung 4, dass Signale, Daten und Informationen zwischen der Sensoreinrichtung 13 und der Steuerungseinrichtung 4 ausgetauscht werden können. Alternativ kann die Sensoreinrichtung 13 auch in einer Platine der Steuerungseinrichtung integriert sein. Die Platine ist in den Figuren nicht gezeigt.

Das Hebelelement 10 ist im Wesentlichen als länglicher Hebelarm mit einem ersten Ende 10a und zweiten Ende 10b sowie mit einer Ober- und Unterseite 10c, 10d ausgestaltet. Das Hebelelement 10 ist mit dem ersten Ende 10a über den Drehpunkt D1 in eine Drehrichtung C oder D reversibel schwenkbar zu dem Gehäuse 2 der Werkzeugmaschine 1 montiert. Wenn eine Kraft in Richtung A auf die Oberseite 10c des Hebelelements 10 ausgeübt wird, schwenkt das Hebelelement 10 um den Drehpunkt D1 in Drehrichtung C. Wenn keine Kraft mehr auf die Oberseite 10c des Hebelelements 10 ausgeübt wird, schwenkt das Hebelelement 10 um den Drehpunkt D1 mit Hilfe eines ersten Federelements 15 in Drehrichtung D in die Ausgangsposition zurück. Das erste Federelement 15 kann dabei in Form einer Spiralfeder oder Drehstabfeder ausgestaltet sein.

Der Signalgeber 14 ist fest mit dem Hebelelement 10 verbunden und in Form eines Magneten ausgestaltet. Bei dem Magneten kann es sich um einen Permanentmagnet handeln. Wie in den Figuren 2a bis 2c gezeigt ist der als Magnet ausgestaltete Signalgeber 14 am dem Hebelelement 10 positioniert. Durch die Positionierung an dem Hebelelement 10 kann der Signalgeber 14 relativ zu dem Gehäuse 2 der Werkzeugmaschine 1 bewegt werden.

Die Sensoreinrichtung 13 ist an der ersten Seitenwand 2a des Gehäuses 2 der Werkzeugmaschine 1 positioniert und enthält im Wesentlichen einen ersten, zweiten und dritten Hall-Sensor 16a, 16b, 16c.

Alternativ kann auch anstelle der Hall-Sensoren auch wenigstens ein 3D-Hallsensor verwendet sein.

Wie in den Figuren 2a bis 2c gezeigt, sind die drei Hall-Sensoren 16a, 16b, 16c untereinander in Richtung A an dem Gehäuse 2 der Werkzeugmaschine 1 positioniert. Die Hall-Sensoren 16a, 16b, 16c sind so an dem Gehäuse 2 der Werkzeugmaschine 1 positioniert, dass stets wenigstens einer der drei Hall-Sensoren 16a, 16b, 16c die Position des als Magneten ausgestalteten Signalgebers 14 detektieren kann, wenn das Hebelelement 10 in Drehrichtung C oder D geschwenkt wird.

Gemäß einer alternativen Ausgestaltungsform können auch mehr oder weniger als drei Hall-Sensoren vorgesehen sein. Entsprechend einer weiteren alternativen Ausgestaltungsform kann anstelle der drei Hall-Sensoren auch lediglich ein 3D-Hallsensor vorhanden sein. Bei dem Hall-Sensor kann es sich um einen Analogsensor handeln.

Wie bereits vorstehend erwähnt, ist in Figur 2a das Aktivierungselement 12 nicht in Richtung A gedrückt und die Handgriffvorrichtung 5 ist nicht durch Ausüben einer Kraft in Richtung C geschwenkt. Der erste (d.h. oberste) Hall-Sensor 16a der Sensoreinrichtung 13 erfasst die Nähe des als Magneten ausgestalteten Signalgebers 14. Die Sensoreinrichtung 13 sendet ein entsprechendes Signal an die Steuerungseinrichtung 4, um der Steuerungseinrichtung 4 mitzuteilen, dass keine Kraft auf die Handgriffvorrichtung 5 ausgeübt wird. In diesem Zustand ist weder der Antrieb 3 noch die Übertragungseinrichtung 6 aktiviert. Folglich wird keine Schlagenergie auf das Werkzeug 9 übertragen. Beispielsweise könnte ein Werkzeugwechsel in diesem Zustand sicher vorgenommen werden.

In Figur 2a ist die Handgriffvorrichtung 5 sowie in einer ersten Position dargestellt. In dieser ersten Position befindet sich die Handgriffvorrichtung 5 und Signalgeber 14 in Richtung B in der obersten Position.

Der als Magnet ausgestaltete Signalgeber 14 ist dabei so positioniert, dass der erste (d.h. der in Richtung B oberste) Hall-Sensor 16a der Sensoreinrichtung 13 den Magneten erfassen kann. Die Sensoreinrichtung 13 erfasst somit, dass sich der Signalgeber 14 und auch die Handgriffvorrichtung 5 in der obersten Position befindet. Wenn die Sensoreinrichtung 13 mit Hilfe des ersten Hall-Sensors 16a die oberste Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass noch keine Kraft von dem Anwender auf die Handgriffvorrichtung 5 in Richtung A ausgeübt wird.

Ein nicht gezeigter Anwender übt eine erste Kraft in Richtung A auf das Aktivierungselement 12 und die Handgriffvorrichtung 5 aus. Hierdurch wird das Aktivierungselement 12 von der ersten Position in die zweite Position gebracht. Der Antrieb 3 wird daraufhin aktiviert, d.h. der Rotor des Antriebs 3 dreht sich und erzeugt ein Drehmoment. Gleichzeitig wird durch das Ausüben der ersten Kraft in Richtung A die Handgriffvorrichtung 5 und damit das Hebelelement 10 um den Drehpunkt D1 in Drehrichtung C geschwenkt.

In Figur 2b ist angedeutet, dass so viel Kraft auf die Handgriffvorrichtung 5 und das Hebelelement 10 ausgeübt wird, dass sich die Handgriffvorrichtung 5 von der ersten Position (d.h. obersten Position in Richtung B) in eine zweite Position (d.h. eine mittlere Position - ungefähr zwischen der obersten und untersten Position) befindet. Der als Magnet ausgestaltete Signalgeber 14 ist dabei so positioniert, dass der zweite (mittlere) Hall-Sensor 16b der Sensoreinrichtung 13 den Magneten erfassen kann. Die Sensoreinrichtung 13 erfasst somit, dass sich die Handgriffvorrichtung 5 in einer mittleren Position befindet. Wenn die Sensoreinrichtung 13 mit Hilfe des zweiten Hall-Sensors 16b die mittlere Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass eine mittlere Kraft von dem Anwender auf die Handgriffvorrichtung 5 ausgeübt wird. Die Distanz zwischen der ersten und zweiten Position des Signalgebers 14 entspricht einer ersten Wegstrecke S1. Die Wegstrecke S1 kann auch als Kreisbogen bezeichnet werden.

Durch das Erfassen der ersten Position und der zweiten Position des Signalgebers 14 mit Hilfe der Sensoreinrichtung 13 ermittelt die Steuerungseinrichtung 4 die Differenz zwischen einer maximalen Wegstrecke S2 des Hebelelements 10 und der ersten ermittelten Wegstrecke S1. Die maximale Wegstrecke S2 entspricht dabei der untersten oder auch tiefsten Stellung der Handgriffvorrichtung 5 in Richtung A, vgl. Figur 2c. Je mehr Hall-Sensoren 16a, 16b, 16c in der Sensoreinrichtung 13 enthalten sind, desto genauer kann die Position des Signalgebers 14 relativ zu der Sensoreinrichtung 13 und schließlich die Differenz zwischen einer maximalen Wegstrecke S2 des Hebelelements 10 und der ersten ermittelten Wegstrecke S1 bestimmt werden. Durch die alternative Verwendung eines 3D-Hallsensors anstelle der drei Hall-Sensoren kann eine maximal mögliche kontinuierlich lineare Positionsbestimmung über den gesamten (d.h. die maximal mögliche) Wegstrecke S2 ermittelt werden.

Die Steuerungseinrichtung 4 stellt eine erste Drehzahl für den Antrieb 3 ein, wenn die ermittelte Differenz zwischen der maximalen Wegstrecke S2 des Hebelelements 10 und der ermittelten Wegstrecke S1 wenigstens einem vorbestimmten Schwellwert entspricht. In dem vorliegenden Ausführungsbeispiel beträgt der Schwellwert 50%. Wenn also die erste Wegstrecke S1 als 50% oder die Hälfte der maximalen Wegstrecke S2 ermittelt wird, stellt die Steuerungseinrichtung 4 eine Drehzahl bzw. einen Drehzahlwert für den Antrieb 3 ein, der 50% bzw. die Hälfte der maximalen Drehzahl des Antriebs 3 entspricht. Mit anderen Worten: wenn die Steuerungseinrichtung 4 ermittelt, dass die Handgriffvorrichtung 5 zur Hälfte bzw. 50% der möglichen Wegstrecke in Richtung A gedrückt ist, wird die Hälfte bzw. 50% der maximal möglichen Drehzahl für den Antrieb 3 eingestellt. Durch das Einstellen der Drehzahl auf die Hälfte bzw. 50% der maximal möglichen Drehzahl für den Antrieb 3 wird lediglich die Hälfte bzw. 50% der maximal möglichen Schlagfrequenz sowie die Hälfte bzw. 50% der maximal möglichen Leistung von der Übertragungseinrichtung 6 erzeugt.

Wenn sich die Handgriffvorrichtung 5 in der ersten Position befindet, d.h. zur Hälfte (50%) der maximalen Wegstrecke S2 bewegt ist, und nach Erreichen dieser zweiten Position der Handgriffvorrichtung 5 zusätzlich eine vorbestimmte Zeitdauer abgelaufen ist, wird eine zweite Drehzahl für den Antrieb 3 durch die Steuerungseinrichtung 4 eingestellt. In dem vorliegenden Ausführungsbeispiel beträgt die zweite Drehzahl die maximale Drehzahl des Antriebs 3. Die maximale Drehzahl entspricht dabei der nominalen Drehzahl des Antriebs 3. Die vorbestimmte Zeitdauer beträgt in diesem vorliegenden Ausführungsbeispiel eine Sekunde. Mit anderen Worten: der Anwender bewegt die Handgriffvorrichtung 5 zur Hälfte der möglichen Wegstrecke S2 in Richtung A und eine erste Drehzahl wird eingestellt, nach einer Sekunde wird eine zweite, höhere Drehzahl eingestellt. Durch die höhere Drehzahl wird eine entsprechend höhere Schlagfrequenz sowie Leistung von der Übertragungseinrichtung 6 erzeugt und auf das Werkzeug 9 übertragen.

Folglich wird die nominale Drehzahl bzw. die volle oder auch maximale Drehzahl für den Antrieb 3 eingestellt entweder durch das plötzliche Einstellen der Handgriffvorrichtung 5 von der ersten in die dritte Position, vgl. Figur 2c, oder durch das Einstellen der Handgriffvorrichtung 5 von der ersten in die zweite Position sowie zusätzlich nach Ablauf der vorbestimmten Zeitdauer nach dem Erreichen der zweiten Position.

In Figur 2c wird eine zweite Kraft in Richtung A auf die Handgriffvorrichtung 5 ausgeübt. Die zweite Kraft ist dabei größer als die erste Kraft. Wie in Figur 2c ersichtlich befindet sich das Aktivierungselement 12 weiterhin in der zweiten (d.h. gedrückten) Position. Der Antrieb 3 ist durch das Drücken des Aktivierungselements 12 in Richtung S weiterhin aktiviert. Durch das Ausüben der zweiten (d.h. erhöhten) Kraft in Richtung A auf die Handgriffvorrichtung 5 wird das Hebelelement 10 weiter als in Figur 2b in Drehrichtung C geschwenkt. Das Hebelelement 10 wird dabei soweit geschwenkt, dass sich die Handgriffvorrichtung 5 in eine dritte Position bewegt und sich der an dem Hebelelement 10 positionierte Signalgeber 14 auf Höhe des dritten (d.h. tiefsten) Hall-Sensors 16c befindet. Die Sensoreinrichtung 13 erfasst somit, dass maximaler Druck auf die Handgriffvorrichtung 5 ausgeübt wird und sich die Handgriffvorrichtung 5 in einer dritten bzw. unteren (d.h. tiefsten) Position befindet. Wenn die Sensoreinrichtung 13 mit Hilfe des dritten Hall-Sensors 16c die unterste Position der Handgriffvorrichtung 5 erfasst, wird ein entsprechendes Signal an die Steuerungseinrichtung 4 gesendet. Durch das Signal wird der Steuerungseinrichtung 4 mitgeteilt, dass eine maximale Kraft von dem Anwender auf die Handgriffvorrichtung 5 ausgeübt wird. Die Steuerungseinrichtung 4 steuert den als Elektromotor ausgestalten Antrieb 3 so an, dass in Abhängigkeit der maximalen Kraftausübung auf die Handgriffvorrichtung 5 eine zweite Drehzahl für den Antrieb 3 eingestellt wird. Der zweite Drehzahlwert ist dabei höher als der erste Drehzahlwert. Durch die zweite Drehzahl wird ein zweiter Wert an Schlagfrequenz und Leistung von der Übertragungseinrichtung 6 auf das Werkzeug 9 gegeben.

Somit wird das Einstellen der maximal möglichen Drehzahl für den Antrieb 3 bzw. für das Einstellen der maximal möglichen Schlagfrequenz und Leistung der Übertragungseinrichtung 6 entweder dadurch bewirkt, dass die Handgriffvorrichtung 5 direkt von der ersten in die dritte Position bewegt wird (vgl. Figur 2a und 2c), oder dadurch, dass die Handgriffvorrichtung 5 in die zweite Position bewegt (vgl. Figur 2b) und dort für eine Sekunde verbleibt.

Die Steuerungseinrichtung 4 ist ausgestaltete, um für den Antrieb 3 eine bestimmte Drehzahl einzustellen. Hierzu wird zunächst durch die Sensoreinrichtung 13 eine erste und zweite Position des Hebelelements 10 mit dem Signalgeber 14 relativ zu der Sensoreinrichtung 13 erfasst. Die zweite Position ist dabei in Richtung A unterhalb der ersten Position und damit ist die erste Position näher an dem Werkzeug 9. Die Daten der ersten und zweiten Position werden von der Sensoreinrichtung 13 an die Steuerungseinrichtung 4 gesendet.

Die dritte Drehzahl ist ebenfalls höher als die erste und zweite Drehzahl. Durch die erhöhte (d.h. dritte) Drehzahl für den Antrieb 3 wird auch eine erhöhte Schlagenergie von der Übertragungseinrichtung 6 erzeugt und an das Werkzeug 9 übertragen.

Wenn die Handgriffvorrichtung 5 durch das Ausüben eine entsprechend geringeren Kraft in Richtung A von der dritten Position wieder in die zweite oder erste Position (in Richtung B) bewegt ist, wird die dritte Drehzahl wieder entsprechend auf die zweite oder erste Drehzahl reduziert.

### Bezuaszeichenliste

- 1: Werkzeugmaschine
- 2: Gehäuse
- 2a: erste Seite des Gehäuses
- 2b: zweite Seite des Gehäuses
- 3: Antrieb
- 4: Steuerungseinrichtung
- 5: Handgriffvorrichtung
- 6: Übertragungseinrichtung
- 7: Energieversorgungseinrichtung
- 8: Werkzeugaufnahme
- 9: Werkzeug
- 10: Hebelelement
- 10a: erstes Ende des Hebelelements
- 10b: zweites Ende des Hebelelements
- 10c: Oberseite des Hebelelements
- 10d: Unterseite des Hebelelements
- 11: Griffstück
- 12: Aktivierungselement
- 13: Sensoreinrichtung
- 14: Signalgeber
- 15: erstes Federelement
- 16a: erster Hall-Sensor
- 16b: zweiter Hall-Sensor
- 16c: dritter Hall-Sensor
- D1: Drehpunkt
- S1: erste Wegstrecke
- S2: maximale Wegstrecke

## Patentansprüche

1. Verfahren zum Steuern und Regeln einer Werkzeugmaschine (1), insbesondere eines Meißelhammers, enthaltend einen Antrieb (3), eine Steuerungseinrichtung (4), eine Sensoreinrichtung (13), einer Übertragungseinrichtung (6) und einer Handgriffvorrichtung (5), wobei die Handgriffvorrichtung (5) ein Hebelelement (10) mit einem Signalgeber (14) enthält, welches relativ zu der Sensoreinrichtung (13) schwenkbar ist,
**gekennzeichnet durch** die Verfahrensschritte
- Erfassen einer ersten und zweiten Position des Signalgebers (14) durch die Sensoreinrichtung (13), wobei die Distanz zwischen der ersten und zweiten Position einer ersten Wegstrecke (S1) entspricht;
- Ermitteln der Differenz zwischen einer maximalen Wegstrecke (S2) des Hebelelements (10) und der ersten ermittelten Wegstrecke (S1);
- Einstellen einer ersten Drehzahl für den Antrieb (3), wenn die ermittelte Differenz zwischen der maximalen Wegstrecke (S2) des Hebelelements (10) und der ersten ermittelten Wegstrecke (S1) wenigstens einem ersten vorbestimmten Schwellwert entspricht; und
- Einstellen einer zweiten Drehzahl für den Antrieb (3), wenn ab dem Erreichen der zweiten Position des Signalgebers (14) eine vorbestimmte Zeitdauer abgelaufen ist.

2. Verfahren nach Anspruch 1,
**dadurch gekennzeichnet, dass** die erste Drehzahl für den Antrieb (3) einem vorbestimmten Anteil, insbesondere zwischen 60 und 80%, beispielsweise 75% der maximalen Drehzahl für den Antrieb (3) entspricht.

3. Verfahren nach Anspruch 1 oder 2,
**dadurch gekennzeichnet, dass** der Schwellwert für die ermittelte Differenz zwischen der maximalen Wegstrecke (S2) und der ersten ermittelten Wegstrecke (S1) des Hebelelements (10) einem vorbestimmten Anteil, insbesondere zwischen 25 und 75%, beispielsweise 50% der maximalen Wegstrecke (S2) entspricht.

4. Verfahren nach wenigstens einem der Ansprüche 1 bis 3,
**dadurch gekennzeichnet, dass** die vorbestimmte Zeitdauer einem Wert zwischen 0,75 und 2 Sekunden und insbesondere 1 Sekunde entspricht.
